# EUROPEAN PATENT SPECIFICATION

(11) **EP 1 943 683 B1**
(45) Date of publication and mention of the grant of the patent: **23.03.2011**
(21) Application number: 06836376.1
(22) Date of filing: 19.10.2006
(51) Int. Cl.: H01L 31/05

(54) **Photovoltaic modules and interconnect methodology for fabricating the same**
Photovoltaische Module und Verbindungsverfahren zu deren Herstellung
Modules photovoltaiques et procédé d'interconnexion pour leur fabrication

(30) Priority: 28.10.2005 US 261025
(43) Date of publication of application: 16.07.2008
(73) Proprietor: GENERAL ELECTRIC COMPANY, Schenectady, NY 12345 (US)
(72) Inventor: FARQUHAR, Donald, Seton, Niskayuna, NY 12309 (US); JOHNSON, Neil, Anthony, Schenectady, NY 12309 (US)
(74) Representative: Bedford, Grant Richard
(86) International application number: PCT/US2006/040772
(87) International publication number: WO 2007/053306

(56) References cited:
- US-A- 3 973 996
- US-A- 4 617 722
- US-A- 6 156 967

## Description

### BACKGROUND

The invention relates generally to solar cells, and more particularly but not exclusively to structures for interconnecting solar cells.

Solar cells, also referred to as photovoltaic cells, are well known devices for converting solar radiation to electrical energy. They may be fabricated on a semiconductor wafer using semiconductor processing technology. Solar cells generally include one or more photoactive materials sandwiched between two electrodes. A typical solar cell includes n-doped and p-doped regions fabricated on a silicon substrate. Solar radiation impinging on the solar cell creates electrons and holes that migrate to the p-doped and n-doped regions respectively, creating voltage differentials between the doped regions.

Individual solar cells generate only a small amount of power, usually much less power than is required by most applications. Desired voltage and current for practical applications is realized by interconnecting a plurality of solar cells in a series and parallel matrix. This matrix is generally referred to as a solar cell array, and can be used to generate electrical energy from solar radiation for a variety of applications. Currently, conventional crystalline silicon photovoltaic (PV) cells are interconnected using a process known as "stringing" to form a module. Stringing cells together in a series network generally involves connecting the front electrode of one cell to the back electrode of an adjacent cell via a conductive path, such as copper wire, extending from the front side of one cell to the back side of the adjacent cell. The strings of cells are placed in a laminate structure, and then the strings are soldered together, creating a single ended connection of one device to another in a series network. That is to say that an electrical path is provided from only one end of the cell to one end of the adjacent cell.

Current industry standards for fabricating solar cell arrays include stringing cells end to end and then forming a laminate consisting of front layer of a glass and backsheets containing materials such as TEDLAR^{®} PVF (polyvinyl fluoride) films (available from E.I. du Pont de Nemours and Company). Such practices are entrenched in the industry because a large database of reliability data exists for such PV laminates. But problems with PV laminates include limited packing density, electrical resistive losses, and lack of automation in assembly that can result in damage and contamination. The strings of cells that are constructed during assembly are fragile, difficult to handle, and require manual operations to repair or rework. Accordingly, standard fabrication techniques lack the automation of the microelectronics electronic card assembly and test infrastructure and exhibit relatively poor yield, inexact placement of the cells, and difficult manual rework operations.

Document US-A-6156967 discloses a solar cell array, comprised of cells with wrap-around contact configurations. Each cell in the array has a plurality of "front" and "back" contacts, i.e. contacts to the front and to the back electrode, with all such contacts being disposed on the back side of the cell. Each cell further comprises conductive elongate tabs that extend along the front side of the cell, where they form contacts to the front electrode, and then wrap around the edges of the cell and are connected to the aforementioned "front" contacts on the back side. Adjacent cells in the array are connected via interconnect leads that extend from the "front" contacts at one end of a cell to the "back" contacts of an adjacent cell.

US 3, 973, 996 discloses a diffusion welded solar cell array.

Accordingly, a technique is needed to address one or more of the foregoing problems in fabricating solar cell assemblies.

### BRIEF DESCRIPTION

The invention is defined by the independent claims.

Various aspects and embodiments of the present invention are defined by the dependent claims.

### DRAWINGS

These and other features, aspects, and advantages of the present invention will become better understood when the following detailed description is read with reference to the accompanying drawings in which like characters represent like parts throughout the drawings, wherein:
FIG. 1 is an exploded view of a photovoltaic module that may be fabricated in accordance with embodiments of the present invention;
FIG. 2 is a cross sectional view of a conventional photovoltaic cell illustrating the front contacts on a front side and back contacts on a back side of the photovoltaic cell;
FIG. 3 is a cross-sectional view of an exemplary photovoltaic cell illustrating the adaptation of a front contact point to a back side of a photovoltaic cell in accordance with embodiments of the present invention;
FIG. 4 illustrates a portion of a photovoltaic cell array and a mechanism for providing multiple current paths to a back side and front side of a photovoltaic cell in accordance with embodiments of the present invention;
FIG. 5 is a plan view of the back side of a portion of a photovoltaic cell array illustrating a double-ended connection scheme achieved by point to point wiring in accordance with embodiments of the present invention;
FIG. 6 is a plan view of the back side of a portion of a photovoltaic cell array illustrating the interconnection scheme between photovoltaic cells comprising two front and back contact points in accordance with embodiments of the present invention;
FIG. 7 is a plan view of the back side of a portion of a photovoltaic cell array illustrating the interconnection scheme between photovoltaic cells comprising individual back contact cells that are connected to each other by preformed interconnect leads prior to assembly of the array; and
FIG. 8 is a flow chart representation of the steps involved in manufacturing a solar cell array in accordance with the double-ended interconnection scheme of FIG. 4, in accordance with embodiments of the present invention.

### DETAILED DESCRIPTION

As discussed in detail below, embodiments of the present invention provide a solar cell array comprising multiple photovoltaic cells, wherein each photovoltaic cell includes a front side and a back side. The solar cell array also includes multiple front contacts and back contacts on the front and back side respectively. One or more conductive tabs are electrically coupled to the front contacts and are configured to provide electrical paths from the front contacts to the back side of the photovoltaic cell. The solar cell array further includes multiple interconnect leads that connect tabs on the back side of each photovoltaic cell to at least one back contact on the back side of another photovoltaic cell. Other embodiments wherein at least two parallel current paths are provided at the back side and the front side of each photovoltaic cell and a method for manufacturing a photovoltaic cell array are also discussed.

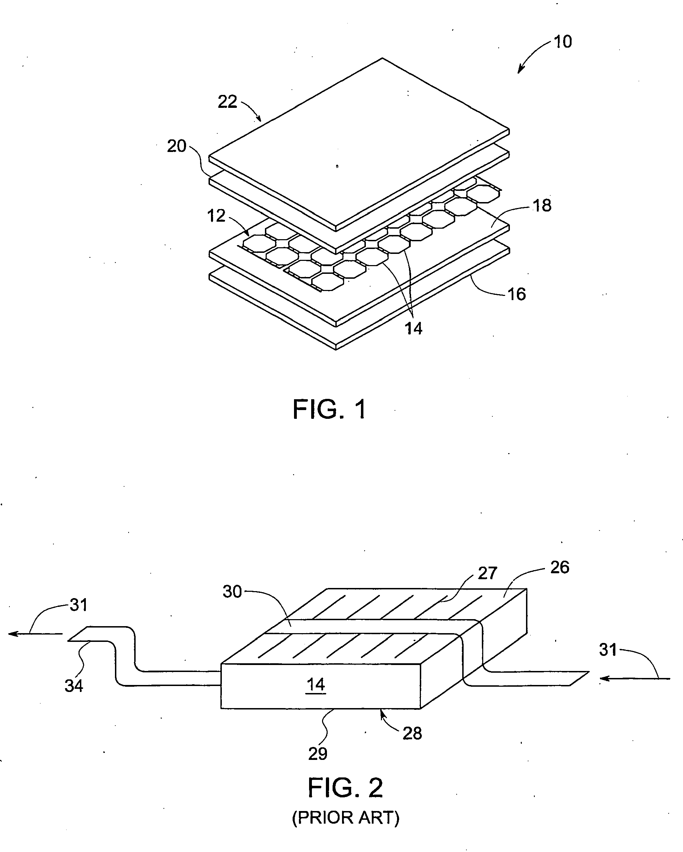

FIG. 1 is an illustration of a photovoltaic (or solar) module 10 in accordance with an exemplary embodiment of the present invention. As will be appreciated, the terms "photovoltaic" and "solar" are used interchangeably throughout the application. Photovoltaic module 10 includes a solar cell array 12 that includes photovoltaic cells 14 which are laminated between lamination layers 18 and 20. As a non-limiting example, lamination layers 18 and 20 may comprise sheets of ethylene vinyl acetate (EVA) material, the selection and use of which is known to those skilled in the art. The photovoltaic module 10 may also include outer protective layers 16 and 22, as well. The outer protective layers 16 and 22 may be configured to protect the solar cell array 12 from environmental conditions such as moisture and humidity, as well as to provide structural durability and protection from certain mechanical forces. The protective layer 16 may comprise a transparent material, such as glass, and the protective layer 22 may comprise a backsheet material comprising one or more layers of polymeric materials, generally including a outermost layer of polyvinyl fluoride, such as TEDLAR^{®} PVF, for example. The selection and use of these materials are known to those skilled in the art. During fabrication, the photovoltaic module 10 may be placed in a laminator such that the lamination layers 18 and 20 may be heated to hermetically seal the photovoltaic module 10. During operation, the photovoltaic module 10 is oriented such that layer 16 faces the sun. Accordingly, in the present exemplary embodiment, the front side of each of the solar cells 14 of the solar cell array 12 is configured to receive sunlight and is oriented to face the protective layer 16. The back side of each of the solar cells 14 of the solar cell array 12 is oriented to face the protective layer 22.

An individual solar cell 14 with an interconnect system that is known in the art is shown in FIG 2. The front side 26 of the cell 14 includes a pattern of conductive grid lines 27 that transmit electrical current from the photovoltaic conversion of photons to electrons. The grid lines 27 are electrically connected to a conductive tab 30 on the front side. The back side 28 of the cell 14 includes a uniform coating of conductive material 29 that distributes current from a conductive tab 34 across the back of the photovoltaic cell. Incident solar radiation is converted to electrical energy and results in the generation of current across the cell, as depicted by the current flow indicated by the arrows 31. This wining configuration is commonly used for interconnecting silicon solar cells, and is referred to as a single-ended series network. In practice, the cells may vary in size from less then 1 inch to as much as 8 inches or more. Depending on the size the cell, one (as shown in FIG. 2) or more parallel pairs of conductive tabs 30 and 34 may be configured to provide adequate conductivity to collect the current efficiently.

As the current 31 is distributed across the front side 26 and back side 28 of the solar cell 14 by means of elements 27 and 29, the current along the conductive tabs 30 and 34 linearly increases or decreases along their length. Whereas the current is varying, the cross-section and resistance per unit length of the conductive tabs 30 and 34 is typically constant, and greatest power loss per unit length occurs where the current is at a maximum. Thus, adopting a wiring configuration that can limit the maximum current would reduce power loss, and adopting a configuration that provides excess current capacity would increase shadowing as explained below.

In the configuration of FIG. 2, the conductive tab 30 and grid lines 27 have the effect of obscuring part of the cell from incident radiation and thus reducing its overall efficiency. It is therefore desirable to reduce the total area covered by the tabs 30 and 34. Reducing the width to height ratio of the conductive tab 30, also reduces the surface area covered by the conductive tab, but may have deleterious effects on the reliability of the assembly due to the difference in mechanical and thermal properties of conductive tab 30 and the solar cell 14. Under thermal excursions typical of solar service conditions, these differences create thermal stresses that may initiate cracks or other damages to the cell. Accordingly, the width to height ratio cannot be altered without the consideration of the impact on thermal stresses.

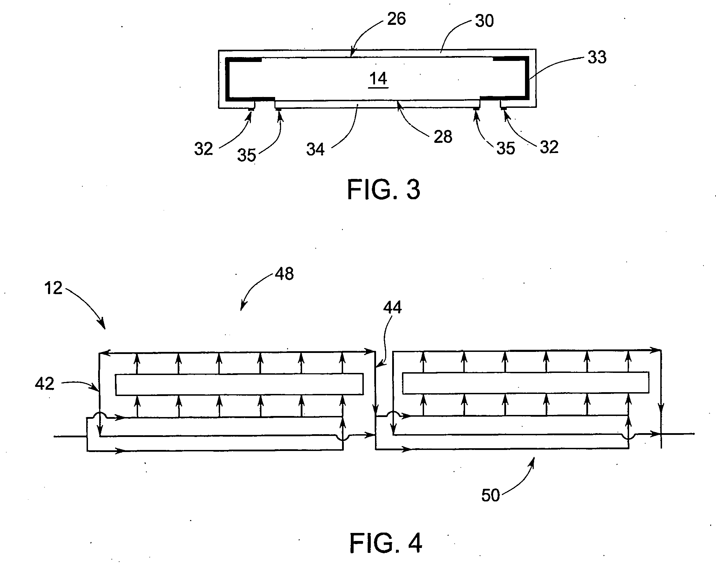

FIG. 3 is a cross-sectional view of a photovoltaic cell 14 that may be coupled to a single-sided contact device, in accordance with embodiments of the present invention. The photovoltaic cell 14 includes a front side 26 and a back side 28. As will be appreciated, the front side 26 of the photovoltaic cell 14 includes a front side electrode on its surface (not shown). Similarly, the back side 28 of the photovoltaic cell 14 includes a back side electrode on its surface (not shown). To provide electrical contact from the front side electrode to the back side 28 of the photovoltaic cell 14, a conductive front side tab 30 is disposed on the front side 26 of the photovoltaic cell 14. The conductive front side tab 30 is electrically coupled to the front side electrode. The conductive front side tab 30 is sized such that the edges of the conductive tab 30 may be wrapped around the edges of the photovoltaic cell 14. The edges of the conductive front side tab 30 are wrapped around such that they provide remote access to front contacts 32 on the back side 28 of the photovoltaic cell 14. An insulator, such as tape 33, may be employed to provide isolation and to act as a spacer between adjacent cells in the series network. Electrically conductive contacts 32 are connected to the front side conductive tab 30 of the photovoltaic cell, but are located physically on the back side of the photovoltaic cell, as illustrated in FIG. 3. The term "back contact configuration" thus refers to a photovoltaic cell configuration wherein its electrically conductive contacts are accessible from the back side as exemplified by contacts 32 and 35 in FIG. 3. In one embodiment of the present invention, a conventional silicon photovoltaic cell with front and rear contacts as depicted in FIG 2 can be restructured into back contact configuration by providing electrically conductive tabs as shown in FIG. 3. In a non-limiting example, conductive tabs 30 and 34 may be copper ribbon that is soldered to the front and back side electrodes on the cell. This back contact configuration provides a conductive tab design that minimizes the resistance losses without increasing shadowing or thermal stresses.

The presently described back contact configuration provides opportunity for improved manufacturability and durability of cell arrays by enabling the individual cells, such as the photovoltaic cell 14, to be placed face down individually in the layup process prior to interconnecting them. In conventional fabrication, the cells are connected into a string prior to placing them down, and the string is fragile and difficult to repair. By placing the individual cells face down and connecting the cells via the front contacts 32 and back contacts 35, the interconnection of the cells in the array is now amenable to a fully automated assembly process.

Providing front contacts 32 and back contacts 35 on the back side 28 of the photovoltaic cell 14 enables a double-ended connection scheme. The term "double ended" refers to connection of adjacent photovoltaic cells at both ends of a back side of the photovoltaic cell, rather than connecting at one end, as in conventional single ended series network type arrays. That is, the front electrode of one photovoltaic cell in an array is coupled to the back electrode of an adjacent array through a first connection between a front contact 32 at one end of a photovoltaic cell 14 and a back contact 35 (conductive tab 34) of an adjacent cell 14, as well as through a second parallel connection between another front contact 32 of the photovoltaic cell 14 and another back contact 35 (conductive tab 34) of the adjacent cell 14. The double-ended connection aspect of the present embodiments will be further illustrated and described with reference to FIGS. 4, 5, 6 and 7.

Referring now to FIG. 4, a schematic representation of the current paths of adjacent photovoltaic cells is illustrated. As discussed above, the front contacts 32 (FIG. 3) provide a mechanism for providing multiple current paths to an adjacent photovoltaic cell as opposed to a single current path. As illustrated in FIG. 4, a solar cell array 12 comprises photovoltaic cells 48 and 50. The current coming from the front side of the photovoltaic cell 48 (via the front contacts 32 of FIG. 3) and going to the back side of the photovoltaic cell 50 (via the conductive tab 34) is essentially split into two current paths 42 and 44. Thus, current will flow from the front (top) side of the cell 48 around both ends and to the back side of the cell 48. The current flows from the front contacts 32 (FIG. 3) of the cell 48 to the back contact 35 (FIG. 3) (conductive tab 34) on the back side of the cell 50 via two current paths, rather than just one, as in conventional arrays. Advantageously, by providing parallel current paths between adjacent cells, resistance losses may be reduced.

Consider an example where 4 Ampere (A) of current (I) flows through the photovoltaic cell. The power loss due to electrical resistance in each photovoltaic cell in the array is equal to I²R where R is the resistance in the current path and I is the current. Hence, in this case, the power loss for 4 A current is 4²R. In the embodiment referred to in FIG. 3, where the current is split in half along two current paths, the power loss is 2² R/2 along each path. The calculation is based on the assumption that the additional wiring paths on the back side are of relatively low resistance. Consequently, the total resistance power loss is reduced to 2² / 4² or 25%. Since the current is constant in a series circuit, the total resistance power percentage remains the same for any number of cells. The net effect on total output of this relative improvement is affected by the design and the operating conditions. It is be noted that under maximum current and peak operating temperatures, where losses are highest, the benefit is maximized. Naturally, solar modules are disposed in locations that tend to maximize their solar exposure, thus the peak current and temperatures conditions are often nominal operating conditions.

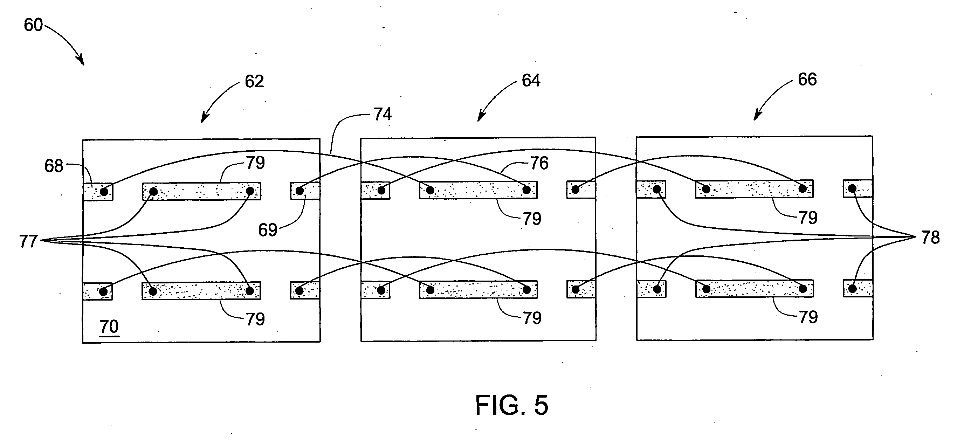

FIG. 5 is a back side plan view of solar cells adapted to have front contacts and back contacts on the back side of each cell and having a double ended interconnection achieved by point-to-point wiring in one of the embodiments. The solar cell array 60 comprises photovoltaic cells 62, 64, and 66, wherein each cell includes front contacts and back contacts on the back side of the cell, as illustrated in FIG. 3. Thus, the photovoltaic cell 62 includes front contacts 68 as well as back contacts 79 on a back side 70 of the cell 62. The cells 64 and 66 are similarly configured. As illustrated in FIG. 5, the front contact 68 of the cell 62 is electrically coupled to the back contact 79 of the cell 64 via an interconnect lead 74. To provide a second parallel current path from the cell 62 to the cell 64, the front contact 69 of the cell 62 is electrically coupled to the back contact 79 of the cell 64 via another interconnect lead 76. Since the front contacts 68 are accessible from the back side 70 of the photovoltaic cells, the interconnection scheme can be double ended, as described above. The wiring pattern can be repeated for an arbitrary number of cells in a series connection, with 77 and 78 depicting the input and output terminals of the network. This is akin to the automated point to point wiring that is widely used in the microelectronics industry for packaging semi-conductors, and the interconnect lead should be selected to minimize resistive losses. The connections can be made after the cells have been physically positioned in their locations for module assembly. Some non-limiting examples of interconnect leads include bus bars as well as insulated wires and ribbons, wherein the wires and ribbons are configured not to overlap with each other.

As can be appreciated, because the solar cells are fabricated to include front contacts on the back side of each cell, access to the front side of the solar cells is no longer necessary in interconnecting the cells to form the cell array. Advantageously, the fabrication of the photovoltaic cell array can be automated, and rework, if required, is simplified because only the affected cell has to be removed, without disturbing the adjacent cells.

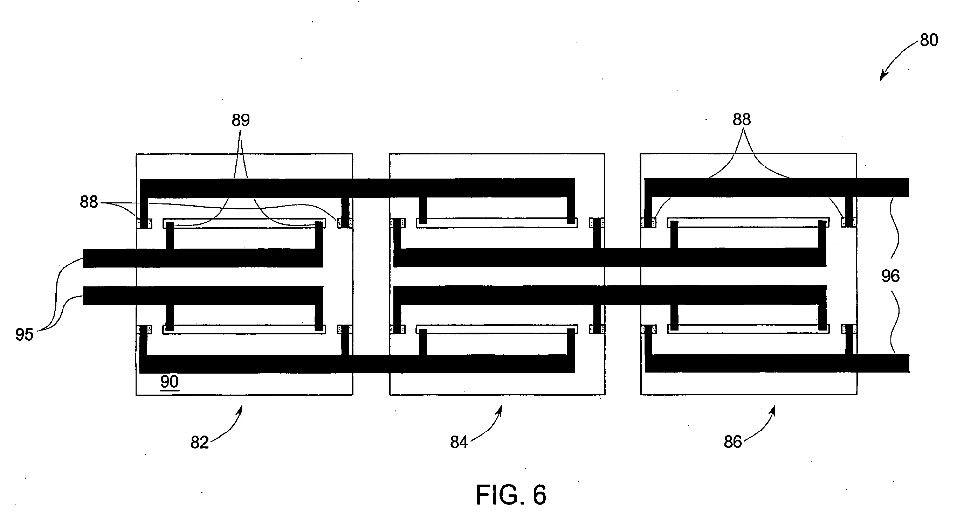

FIG. 6 is a back side plan view of solar cells adapted to have front contacts and back contacts on the back side of each cell and having a double ended interconnection achieved by connecting two points to two points, in accordance with embodiments of the present invention. The solar cell array 80 comprises photovoltaic cells 82, 84 and 86, wherein each cell includes front contacts and back contacts on the back side 90 of the cell, as depicted previously in FIG. 3. Thus, the photovoltaic cell is a back contact cell with the contacts 88 and 89 forming the terminals of the cell.

As shown in FIG. 6, interconnect leads 95 and 96 connect one photovoltaic cell to another. The interconnect leads are constructed of a low resistance material such as copper that may be die cut, machined or etched in any known art. Among other advantages over a single, long interconnect lead, separate interconnect leads require less interconnect material, provide more room for contact points and lower the weight of the solar cell array. Further, the aforementioned embodiment of the present invention requires minimal changes to the existing commercial infrastructure of a photovoltaic cell array. In an exemplary embodiment, the solar cell array 80 can also include passive components (not shown) embedded into the circuitry. A non-limiting example of a passive component includes a bypass diode.

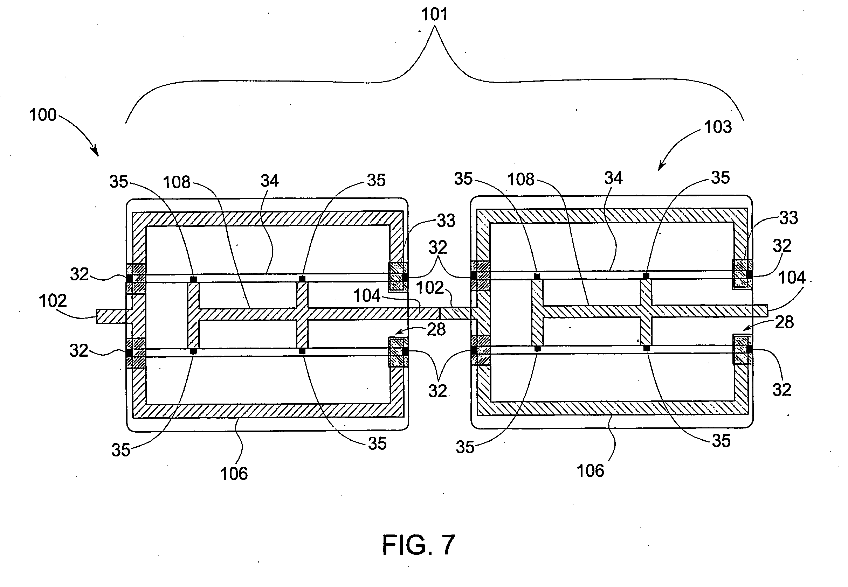

FIG. 7 shows an alternate embodiment in which preformed interconnect leads 106 and 108 are attached to individual back contact cells 100 and 103 prior to assembly of the array. The interconnect leads 106 and 108 may be fabricated on a low electrical resistance material such as copper, and formed by etching, punching or other means to match the dimensions of the back contact cells 100 and 103. Connections are formed through a process such as soldering to contacts 32 and 35. Soldering can be accomplished by contacting the interconnect leads 106 and 108 to their respective locations, and by fluxing and soldering by supplying sufficient heat to connection following means known in the art. The resulting sub-assembly 100 (or 103) can now be tested, and repaired as necessary prior to forming a multi-cell array 101. Connection of the cell 100 to another cell 103 can be accomplished through two points of contact, namely 102 and 104. The back side 28, insulator 33, and tab 34 are also shown in FIG. 7 and have the same respective functions as described previously in reference to FIG. 3.

The process of forming a multi-cell array of cell 101 is accomplished by placing cells in position during the lamination layup step as depicted in FIG. 1. Cell to cell connections are made by soldering the contact 102 of one cell, to the contact 104 of the adjacent cell, and so forth, to form a linear series network. In the case where one linear series network is to be connected to a co-linear adjacent network, connection at the ends can be accomplished by adding a shunting constructed of a solderable and conductive material, for example a copper ribbon. The cells can be placed manually or with an automated method, and the soldering can be accomplished by a manual or automated method by applying a heating device such as a soldering iron to the desired location. This process of assembly obviates the need to pre-assemble strings of cells, transport them to the layup station, and then repair or remove them if they have defects. By contrast, the sequential placement of individual cells 100, 103 by the means described falls into the methodologies that are employed in electronic card assembly and test manufacturing infrastructure which is characterized by automation for pick and place operations and high yielding soldering processes.

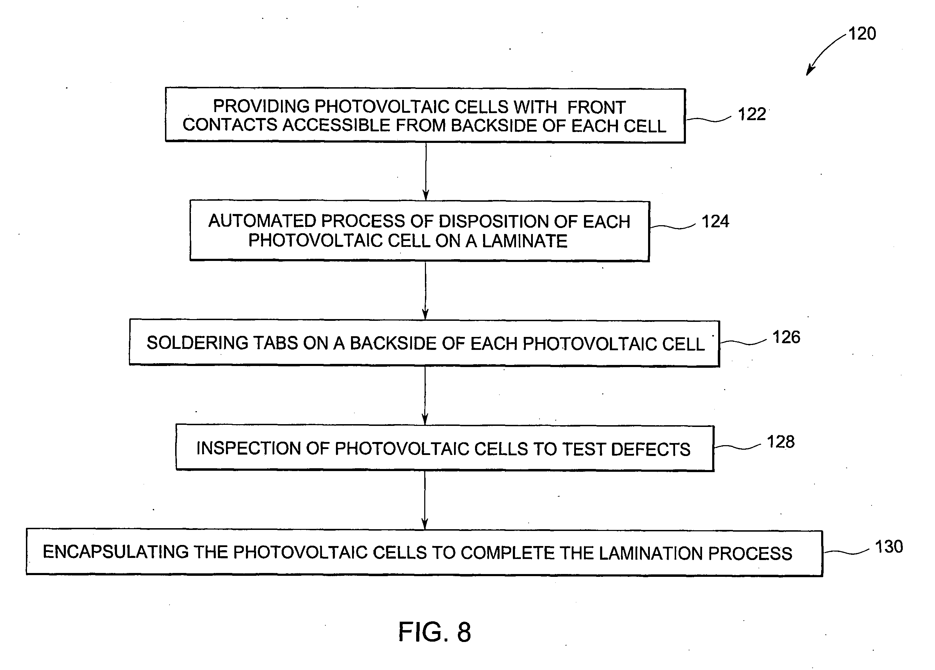

FIG. 8 shows a flow chart illustrating the steps involved in a method of manufacturing 120 of a solar cell array. The individual back contact cells are assembled using interconnect leads as in step 122. Referring to step 124, back contact photovoltaic cells are disposed individually on a laminate stack. A non-limiting example of the laminate stack includes a backsheet of ethylene vinyl acetate or polyvinyl fluoride on glass. The disposition of the photovoltaic cells on the laminate stack is an automated process. Each photovoltaic cell is individually picked and placed on the laminate stack. Further, the method includes tabbing 126 wherein tabs are soldered on a back side of each photovoltaic cell by an automated soldering apparatus. The tabs are designed to help maintain the spacing between the cells throughout the lamination process. The tabs may be insulated. After the cells have been placed, in a non-limiting example, they are tacked in place by using a hot iron. A slight warming of the cell will tack it to the underlying ethylene vinyl acetate and help retain the cell positions. Further, the cells are interconnected to each other in series via interconnect leads. As an example from the embodiment of FIG. 4, the interconnect leads can be insulated wires which may be round or flat. In other embodiments, as described with respect to FIGS. 6 and 7, the interconnect leads comprise copper (or alternately other conductive materials) ribbons that are punched or etched or otherwise manufactured into the desired shape. They may or may not be insulated depending on the process requirements. In general, the EVA flows between the ribbon and the cell providing an insulating layer that forms during the lamination process. As a next step 128, an inspection of the cells is performed to test for a defect. Finally, the lamination process is completed in step 130, wherein the photovoltaic cells are encapsulated using an encapsulant. Some non-limiting examples of encapsulants include ethylene vinyl acetate.

The aforementioned embodiments result in the potential for interconnection between adjacent cells with minimized spacing and thus can be used to improve the packing density and enhance the photovoltaic module output. In a non-limiting example, the permissible spacing between cells is typically at least 1 mm.

From the foregoing description, it is believed evident that the present invention has provided improved solar cell arrays with several advantages including reduced power loss in the circuit and a more convenient interconnect methodology that allows easier replacement of defective cells.

While only certain features of the invention have been illustrated and described herein, many modifications and changes will occur to those skilled in the art.

## Claims

1. A solar cell array (12, 60), comprising:
a plurality of photovoltaic cells (14, 62, 64, 66), each of the plurality of photovoltaic cells (14, 62, 64, 66) comprising a front side (26) and a back side (28);
a plurality of front contacts (32) disposed on the back side (28) and a plurality of back contacts (35) disposed on the back side of each of the plurality of photovoltaic cells (14);
a plurality of front side tabs (30) disposed on the front side of each cell and electrically coupled to the plurality of front contacts (32) on the back side of the photovoltaic cell, with the front contacts (32) disposed at both ends of each cell; a first connection via an interconnet lead (74) between a front contact at one end of a photovoltaic cell (62) and a back contact of an adjacent cell (64) and a second parallel connection vio another interconnect lead (76) between another front contact at the other end of the photovoltaic cell (62) and another back contact of the adjacent cell (64).

2. The array of claim 1, further comprising a laminate stack (18), wherein each photovoltaic cell (14) is disposed on the laminate stack (18).

3. The array of claim 1, further comprising an encapsulant (22) for encapsulating the photovoltaic cell (14).

4. The array of claim 3, wherein the encapsulant (22) comprises ethylene vinyl acetate.

5. The array of claim 1, wherein each of the photovoltaic cells (14) is configured to exhibit a power loss of less than 2 percent of a total power output of the photovoltaic cell (14).

6. A method of manufacturing a photovoltaic cell array (12, 60), comprising:
providing a plurality of photovoltaic cells (14, 62, 64, 66) wherein each of the cells has a front side (26) and a back side (28), and wherein each cell comprises a plurality of front side tabs (30) electrically coupled to front contacts (32) disposed at each end of the cell on the back side of the cell, and a plurality of back side contacts (35) disposed on the back side;
disposing the plurality of the photovoltaic cells (14) on a laminate (18);
heating the photovoltaic cells (14) such that the cells (14) are adhered to the laminate (18); and
interconnecting adjacent photovoltaic cells in series via a first connection via an interconnect lead (74) between a front contact at one end of a photovoltaic cell (62) and a back contact of an adjacent cell (64) and a second parallel connection via another interconnect lead (76) between another front contact at the other end of the photovoltaic cell (62) and another back contact of the adjacent cell (64).

7. The method of claim 6, wherein disposing the plurality of the photovoltaic cells (14) comprises automated picking and placement of each of the photovoltaic cells (14).

8. The method of claim 6, wherein the automated picking and placement of each of the photovoltaic cells (14) further comprises laminating the cells (14) individually and interconnecting them.

## Patentansprüche

1. Solarzellen-Array (12, 60), aufweisend:
mehrere photovoltaische Zellen (14, 62, 64, 66), wobei jede von den photovoltaischen Zellen (14, 62, 64, 66) eine Vorderseite (26) und eine Rückseite (28) aufweist;
mehrere auf der Rückseite (28) angeordnete Vorderseitenkontakte (32) und mehrere auf der Rückseite von jeder der mehreren photovoltaischen Zellen (14) angeordnete Rückseitenkontakte (35);
mehrere Vorderseitenstreifen (30), die auf der Vorderseite jeder Zelle angeordnet und elektrisch mit den mehreren Vorderseitenkontakten (32) auf der Rückseite der photovoltaischen Zellen verbunden sind, wobei die Vorderseitenkontakte (32) an beiden Enden jeder Zelle angeordnet sind;
eine erste Verbindung über eine Zwischenverbindungsleitung (74) zwischen einem Vorderseitenkontakt an einem Ende einer photovoltaischen Zelle (62) und einem Rückseitenkontakt einer benachbarten Zelle (64) und eine zweite parallele Verbindung über eine weitere Zwischenverbindungsleitung (76) zwischen einem anderen Vorderseitenkontakt an dem anderen Ende der photovoltaischen Zelle (62) und einem anderen Rückseitenkontakt der benachbarten Zelle (64).

2. Array nach Anspruch 1, das ferner einen Laminatstapel (18) aufweist, wobei jede photovoltaische Zelle (14) auf dem Laminatstapel (18) angeordnet ist.

3. Array nach Anspruch 1, das ferner eine Einkapselung (22) zum Einkapseln der photovoltaischen Zelle (14) aufweist.

4. Array nach Anspruch 3, wobei die Einkapselung (22) Ethylenvinylacetat aufweist.

5. Array nach Anspruch 1, wobei jede von den photovoltaischen Zellen (14) dafür konfiguriert ist, einen Leistungsverlust von weniger als 2 Prozent einer von der photovoltaischen Zelle (14) ausgegebenen Gesamtleistung zu zeigen.

6. Verfahren zum Herstellen eines photovoltaischen Zellen-Arrays (12, 60), mit den Schritten:
Bereitstellen mehrerer photovoltaischer Zellen (14, 62, 64, 66), wobei jede von den Zellen eine Vorderseite (26) und eine Rückseite besitzt, und wobei jede Zelle mehrere Vorderseitenstreifen (30) aufweist, die elektrisch mit Vorderseitenkontakten (32) verbunden sind, die an jedem Ende der Zelle auf der Rückseite der Zelle angeordnet sind, und mehrere Rückseitenkontakte (35), die auf der Rückseite angeordnet sind;
Anordnen der mehreren photovoltaischen Zellen (14) auf einem Laminat (18);
Erwärmen der photovoltaischen Zellen (14) so, dass die Zellen (14) an dem Laminat (18) anhaften; und
Verbinden benachbarter photovoltaischer Zellen in Reihe mittels einer ersten Verbindung über eine Zwischenverbindungsleitung (74) zwischen einem Vorderseitenkontakt an einem Ende einer photovoltaischen Zelle (62) und einem Rückseitenkontakt einer benachbarten Zelle (64) und einer zweiten parallelen Verbindung über eine weitere Zwischenverbindungsleitung (76) zwischen einem anderen Vorderseitenkontakt an dem anderen Ende der photovoltaischen Zelle (62) und einem anderen Rückseitenkontakt der benachbarten Zelle (64).

7. Verfahren nach Anspruch 6, wobei der Schritt der Anordnung der mehreren photovoltaischen Zellen (14) ein automatisches Aufnehmen und Platzieren von jeder der photovoltaischen Zellen (14) beinhaltet.

8. Verfahren nach Anspruch 6, wobei der Schritt des automatischen Aufnehmens und Platzierens von jeder der photovoltaischen Zellen (14) ferner ein individuelles Laminieren der Zellen (14) und Verbinden dieser untereinander umfasst.

## Revendications

1. Assemblage de cellules solaires (12, 60) comprenant :
une pluralité de cellules photovoltaïques (14, 62, 64, 66), chacune des cellules photovoltaïques (14, 62, 64, 66) comprenant une face avant (26) et une face arrière (28) ;
une pluralité de contacts avant (32) disposés sur la face arrière (28) et une pluralité de contacts arrière (35) disposés sur la face arrière de chacune des cellules photovoltaïques (14) ;
une pluralité de pattes de face avant (30) disposées sur la face avant de chaque cellule et couplées électriquement à la pluralité de contacts avant (32) sur la face arrière de la cellule photovoltaïque, les contacts avant (32) étant disposés aux deux extrémités de chaque cellule ;
une première connexion via un conducteur d'interconnexion (74) entre en contact avant à une extrémité d'une cellule photovoltaïque (62) et un contact arrière d'une cellule adjacente (64) et une deuxième connexion parallèle via un autre conducteur d'interconnexion (76) entre un autre contact avant à l'autre extrémité de la cellule photovoltaïque (62) et un autre contact arrière de la cellule adjacente (64).

2. Assemblage selon la revendication 1, comprenant en outre un empilement stratifié (18), chaque cellule photovoltaïque (14) étant disposée sur l'empilement stratifié (18).

3. Assemblage selon la revendication 1, comprenant en outre un boîtier (22) pour mettre en boîtier la cellule photovoltaïque (14).

4. Assemblage selon la revendication 3, dans lequel le boîtier (22) comprend de l'éthylène-acétate de vinyle.

5. Assemblage selon la revendication 1, dans lequel chacune des cellules photovoltaïques (14) est configurée pour présenter une perte de puissance inférieure à 2 pour cent d'une puissance délivrée totale de la cellule photovoltaïque (14).

6. Procédé de fabrication d'un assemblage de cellules photovoltaïques (12, 60) comprenant les opérations suivantes :
prendre une pluralité de cellules photovoltaïques (14, 62, 64, 66), chacune des cellules comportant une face avant (26) et une face arrière (28), et chaque cellule comprenant une pluralité de pattes de face avant (30) couplées électriquement à des contacts avant (32) disposés à chaque extrémité de la cellule sur la face arrière de la cellule, et une pluralité de contacts de face arrière (35) disposés sur la face arrière ;
disposer la pluralité de cellules photovoltaïques (14) sur un stratifié (18) ;
faire chauffer les cellules photovoltaïques (14) jusqu'à faire adhérer les cellules (14) sur le stratifié (18) ; et
interconnecter les cellules photovoltaïques adjacentes en série par l'intermédiaire d'une première connexion via un conducteur d'interconnexion (74) entre en contact avant à une extrémité d'une cellule photovoltaïque (62) et un contact arrière d'une cellule adjacente (64) et une deuxième connexion parallèle via un autre conducteur d'interconnexion (76) entre un autre contact avant à l'autre extrémité de la cellule photovoltaïque (62) et un autre contact arrière de la cellule adjacente (64).

7. Procédé selon la revendication 6, dans lequel la disposition de la pluralité de cellules photovoltaïques (14) comprend le levage et le positionnement automatisés de chacune des cellules photovoltaïques (14).

8. Procédé selon la revendication 6, dans lequel le levage et le positionnement automatisés de chacune des cellules photovoltaïques (14) comprend en outre le fait de superposer les cellules (14) individuellement puis de les interconnecter.
